# EUROPEAN PATENT APPLICATION

(11) **EP 4 704 137 A2**
(43) Date of publication of application: **04.03.2026**
(21) Application number: 25196361.7
(22) Date of filing: 18.08.2025
(51) Int. Cl.: H01J 37/244

(54) **IN-COLUMN PARTICLE FILTER**

(30) Priority: 29.08.2024 US 202418819676
(71) Applicant: FEI Company, Hillsboro, OR 97124 (US)
(72) Inventor: MAHEL, Vojtech, Borsice u Blatnice (CZ); HLAVENKA, Petr, Brno (CZ); STRAKA, Branislav, Brno (CZ); MACKU, Robert, Brno (CZ)
(74) Representative: Boult Wade Tennant LLP

(57) **Abstract**

Systems, components, and methods are described for protecting a charged particle detector against damage. A filter can include a frame and a membrane of carbon material. The membrane can define a first surface, a second surface opposing the first surface, and an aperture extending through the membrane from the first surface to the second surface. The frame can be configured to couple with a charged particle detector disposed in a charged particle beam column, the charged particle detector defining an absorption surface oriented toward the first surface. The filter can be configured to shield the absorption surface from particles incident on the second surface. The particles can include electrons, ions, or photons.

## Description

### TECHNICAL FIELD

Embodiments of the present disclosure are directed to charged particle beam systems, as well as algorithms and methods for their operation. In particular, some embodiments are directed toward techniques for shielding solid state detectors from energetic particles.

### BACKGROUND

In charged particle microscopy, conventional charged particle detectors are built around a detector cell. The detector cell absorbs an incident charged particle of a given energy and generates a proportional charge that is detected as a current. Conventional detectors are sensitive to incident particles of diverse types. Ions, electrons, photons in the ultraviolet, visible, and/or infrared spectral ranges, and other forms of radiation, can generate electron-hole pairs that give rise to detector current signals. Specificity to one particular type of charged particle (e.g., ions, electrons, photons, etc.) can be difficult to achieve, leading to significant noise content in detector data and degrading detector performance. For example, specificity can depend on selecting a filter material that is robust (e.g., not degraded under operating conditions) and that does not introduce artefacts in detector data.

Focused-ion beam (FIB) and dual-beam (FIB and EM) systems present significant challenges with regard to detector protection techniques. For example, exposure to sputtered material, removed from a sample undergoing FIB processing, can increase a dark current of a solid state detector, for example, by creating conductive layer on top. In another example, the sputtered material and FIB ions can implant into the material of the solid state detector, impairing the charge collection efficiency of the detector. In a third example, a thin layer of sputtered material can impair the quantum detection efficiency of a solid state detector.

As a result of the engineering constraints described above, solid state detectors are typically incompatible with operating conditions and/or systems that would result in significant sputtered material deposition on detector surfaces, based at least in part on susceptibility to noise generated by extraneous signals and sensitivity to degradation by energetic species. There is a need, therefore, for improved solid state detector systems and charged particle filtration.

### BRIEF SUMMARY

The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification and variation of the concepts herein disclosed can be resorted to by those skilled in the art, and that such modifications and variations are considered to be within the scope of this disclosure as defined by the appended claims.

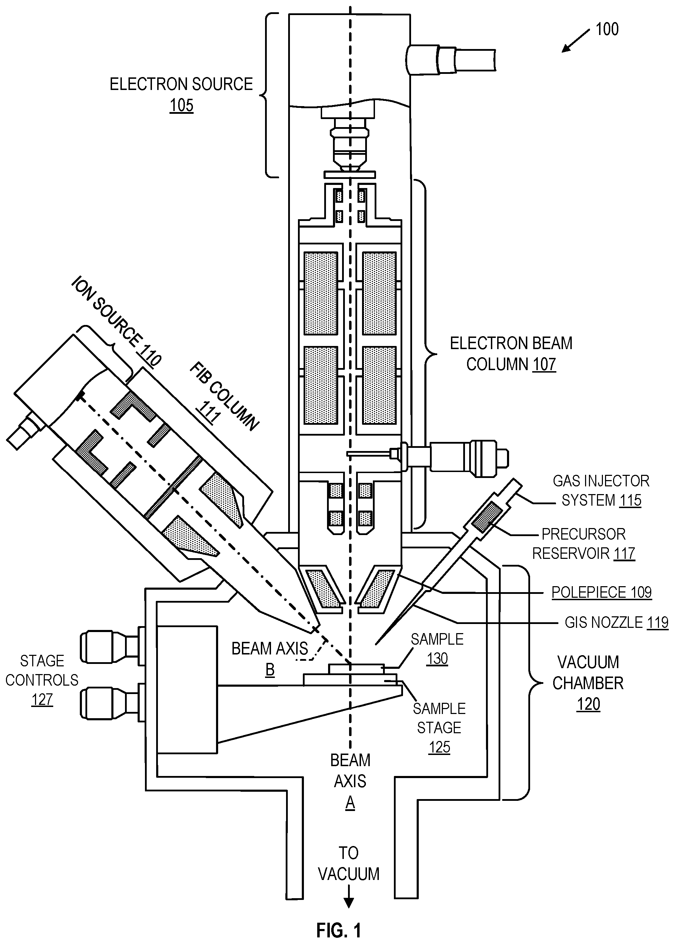

In a first aspect, a filter is described in reference to FIGs. 1-10B. The filter can include a frame and a membrane of carbon material, coupled with the frame. The membrane can define a first surface, a second surface opposing the first surface, and an aperture extending through the membrane from the first surface to the second surface. The frame can be configured to couple with a charged particle detector disposed in a charged particle beam column. The charged particle detector can define an absorption surface oriented toward the first surface. The filter can be configured to shield the absorption surface from particles incident on the second surface. The particles can include electrons, ions, or photons.

In some embodiments, the carbon material includes carbon nanotubes. The carbon material can include a layer of nonwoven carbon nanotube felt. The membrane can include multiple substantially planar layers of carbon material. The membrane can be supported over at least a portion of the membrane by a support material.

In some embodiments, the charged particle detector is disposed in a polepiece of the charged particle beam column. The charged particle detector can be a mirror detector including a mirror electrode. The frame can be configured to couple with the mirror detector. The mirror electrode can define a first end and a second end, the first end being proximal to the absorption surface. The frame can be configured to be disposed proximal to the second end of the mirror electrode and external to the mirror detector. The mirror electrode can define a first end and a second end, the first end being proximal to the absorption surface. The frame can be configured to be disposed in the polepiece, proximal to the first end of the mirror electrode and internal to the mirror detector. The charged particle detector and the mirror electrode can be disposed along a beam axis, and the frame can be disposed on the beam axis between the charged particle detector and the mirror electrode.

In some embodiments, the frame is offset from the absorption surface. The frame can include an electrically conductive portion. The electrically conductive portion can be electrically coupled with the membrane and with a voltage source via a bias circuit.

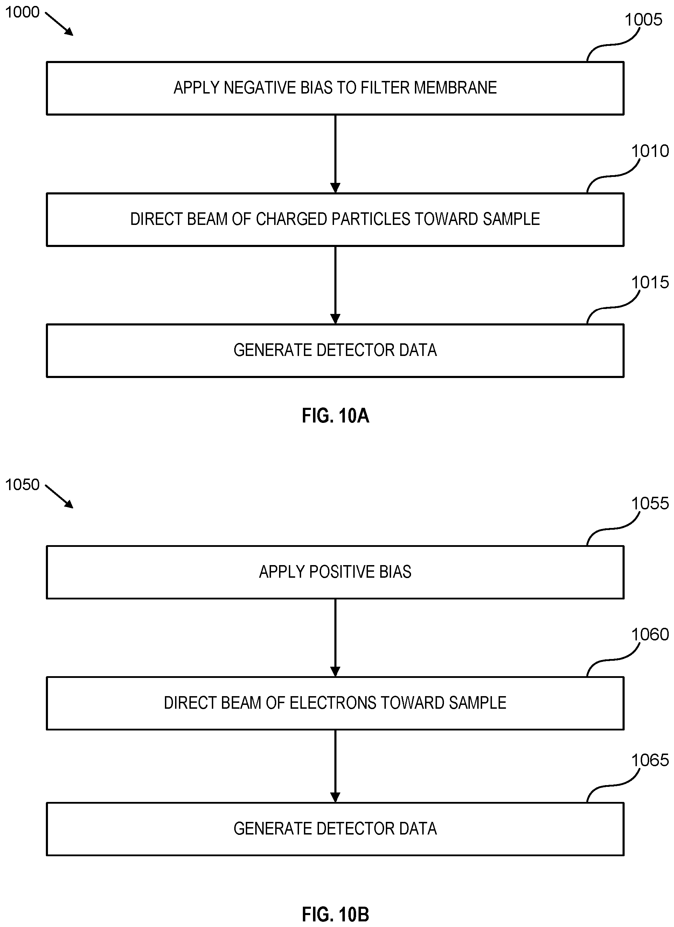

In a second aspect, described in reference to FIGs. 1-10B, a charged particle beam system includes a chamber, configured to receive a sample and to maintain a controlled environment in a vicinity of the sample. The system can include a charged particle beam column, coupled with the chamber and oriented toward the vicinity of the sample. The system can include a charged particle detector, disposed in the charged particle beam column, the charged particle detector defining an absorption surface. The system can include a particle filter in accordance with one or more embodiments of the first aspect.

In some embodiments, the charged particle beam system includes control circuitry, operably coupled with the bias circuit and one or more machine readable media storing instructions that, when read by a machine, cause the control circuitry to perform operations. The operations can include applying a negative bias to the membrane via the electrically conductive portion, wherein the negative bias corresponds to a lower energy cutoff of the particle filter, below which electrons directed toward the second surface are repelled. The operations can include applying a positive bias to the membrane via the electrically conductive portion. The positive bias has a magnitude such that electrons incident on the second surface are characterized by an average energy above a threshold of transmissivity of the membrane for electrons.

In some embodiments, the charged particle detector includes a conductive material disposed over at least a portion of the absorption surface. The charged particle detector can be electrically coupled to a voltage source via a bias circuit. The charged particle beam system can be configured to apply a bias voltage to the conductive material via the bias circuit. In some embodiments, the charged particle detector is a mirror detector including a mirror electrode, and the frame is configured to couple with the mirror electrode or to be disposed between the mirror electrode and the absorption surface.

In a third aspect, a method for active filtering of charged particles is described in reference to FIGs. 10A-10B. The method can be implemented using a charged particle beam system of the second aspect in one or more embodiments and/or a filter of the first aspect in one or more embodiments. The method can include applying a bias to a filter membrane. The bias can have a positive polarity. The bias can have a negative polarity. The bias can be applied via an electrically conductive portion of a frame. The frame can be coupled with at least a portion of the filter membrane. The negative bias can correspond to a lower energy cutoff of the particle filter, below which electrons directed toward the second surface are repelled. The positive bias can increase an energy of an incident electron such that the electron can be transmitted through the filter membrane. In some embodiments, an internal surface of the filter membrane can be electrically isolated. The operations can include electrically grounding the internal surface.

While the present disclosure generally pertains to the specific context of charged particle microscopy, and more specifically to electron microscopy, such descriptions are not intended to be limiting, and it is within the scope of the present disclosure that the apparatuses and methods disclosed herein may be applied in any suitable context.

Further aspects of the invention are set out in the following numbered clauses:
1. A filter, comprising:
   a frame; and
   a membrane of carbon material, coupled with the frame, the membrane defining a first surface, a second surface opposing the first surface, and an aperture extending through the membrane from the first surface to the second surface,
   wherein:
      the frame is configured to couple with a charged particle detector disposed in a charged particle beam column, the charged particle detector defining an absorption surface oriented toward the first surface; and
      the filter being configured to shield the absorption surface from particles incident on the second surface, the particles comprising electrons, ions, or photons.
2. The filter of clause 1, wherein the carbon material comprises carbon nanotubes.
3. The filter of clause 1, wherein the carbon material comprises a layer of nonwoven carbon nanotube felt.
4. The filter of clause 1, wherein the membrane comprises multiple substantially planar layers of carbon material.
5. The filter of clause 1, wherein the membrane is supported over at least a portion of the membrane by a support material.
6. The filter of clause 1, wherein the charged particle detector is disposed in a polepiece of the charged particle beam column.
7. The filter of clause 1, wherein the charged particle detector is a mirror detector including a mirror electrode, and wherein the frame is configured to couple with the mirror detector.
8. The filter of clause 7, wherein the mirror electrode defines a first end and a second end, the first end being proximal to the absorption surface, and wherein the frame is configured to be disposed proximal to the second end of the mirror electrode and external to the mirror detector.
9. The filter of clause 7, wherein the mirror electrode defines a first end and a second end, the first end being proximal to the absorption surface, and wherein the frame is configured to be disposed in the polepiece, proximal to the first end of the mirror electrode and internal to the mirror detector.
10. The filter of clause 7, wherein the charged particle detector and the mirror electrode are disposed along a beam axis, and wherein the frame is disposed on the beam axis between the charged particle detector and the mirror electrode.
11. The filter of clause 1, wherein the frame is offset from the absorption surface.
12. The filter of clause 1, wherein the frame comprises an electrically conductive portion, electrically coupled with the membrane and with a voltage source via a bias circuit.
13. A charged particle beam system, comprising:
   a chamber, configured to receive a sample and to maintain a controlled environment in a vicinity of the sample;
   a charged particle beam column, coupled with the chamber and oriented toward the vicinity of the sample;
   a charged particle detector, disposed in the charged particle beam column, the charged particle detector defining an absorption surface;
   a particle filter, comprising:
      a frame, coupled with the charged particle detector; and
      a membrane of carbon material, coupled with the frame, the membrane defining a first surface, oriented toward the absorption surface, a second surface opposing the first surface, and an aperture extending through the membrane from the first surface to the second surface, wherein the filter is configured to shield the absorption surface from particles incident on the second surface, the particles comprising electrons, ions, or photons.
14. The charged particle beam system of clause 13, wherein the frame comprises an electrically conductive portion, electrically coupled with the membrane and with a voltage source via a bias circuit.
15. The charged particle beam system of clause 14, further comprising:
   control circuitry, operably coupled with the bias circuit; and
   one or more machine readable media storing instructions that, when read by a machine, cause the control circuitry to perform operations including applying a negative bias to the membrane via the electrically conductive portion, wherein the negative bias corresponds to a lower energy cutoff of the particle filter, below which electrons directed toward the second surface are repelled.
16. The charged particle beam system of clause 14, further comprising:
   control circuitry, operably coupled with the bias circuit; and
   one or more machine readable media storing instructions that, when read by a machine, cause the control circuitry to perform operations including applying a positive bias to the membrane via the electrically conductive portion.
17. The charged particle beam system of clause 16, wherein the positive bias has a magnitude such that electrons incident on the second surface are characterized by an average energy above a threshold of transmissivity of the membrane for electrons.
18. The charged particle beam system of clause 13, wherein the charged particle detector comprises a conductive material disposed over at least a portion of the absorption surface, wherein the charged particle detector is electrically coupled to a voltage source via a bias circuit, and wherein the charged particle beam system is configured to apply a bias voltage to the conductive material via the bias circuit.
19. The charged particle beam system of clause 13, wherein the charged particle detector is a mirror detector including a mirror electrode, and wherein the frame is configured to couple with the mirror electrode or to be disposed between the mirror electrode and the absorption surface.
20. The charged particle beam system of clause 13, wherein the membrane comprises multiple substantially planar layers of carbon nanotube material.

### BRIEF DESCRIPTION OF THE SEVERAL VIEWS OF THE DRAWINGS

The foregoing aspects and many of the attendant advantages of the present disclosure will become more readily appreciated as the same become better understood by reference to the following detailed description, when taken in conjunction with the accompanying drawings.
FIG. 1 is a schematic diagram illustrating an example dual-beam system, in accordance with some embodiments of the present disclosure.
FIG. 2 is a schematic diagram of a detail of the example system of FIG. 1, in accordance with some embodiments of the present disclosure.
FIG. 3A is an electron microscope image of a solid state detector surface including undamaged portions and damaged portions, in accordance with some embodiments of the present disclosure.
FIG. 3B is a plot of example detector quantum efficiency data for an undamaged portion of the solid state detector of FIG. 3A, in accordance with some embodiments of the present disclosure.
FIG. 3C is a plot of example detector quantum efficiency data for a damaged portion of the solid state detector of FIG. 3A, in accordance with some embodiments of the present disclosure.
FIG. 4A is a schematic diagram of an example particle filter, in accordance with some embodiments of the present disclosure.
FIG. 4B is a schematic diagram of an example polepiece, in accordance with some embodiments of the present disclosure.
FIG. 4C is a schematic diagram of an example polepiece, in accordance with some embodiments of the present disclosure.
FIG. 5 is a schematic diagram of an example detector, in accordance with some embodiments of the present disclosure.
FIG. 6 is a plot of example transmissivity data for multiple types of detectible signals, in accordance with some embodiments of the present disclosure.
FIG. 7 is a plot of example detection efficiency data as a function of beam energy, in accordance with some embodiments of the present disclosure.
FIG. 8 is a plot of example detector current data for multiple particles and detectors, in accordance with some embodiments of the present disclosure.
FIG. 9A is a plot of example detector current data for an unfiltered solid state detector, in accordance with some embodiments of the present disclosure.
FIG. 9B is a plot of example detector current data for a filtered solid state detector, in accordance with some embodiments of the present disclosure.
FIG. 9C is a plot of example detector leak current data for an unfiltered solid state detector, in accordance with the current art.
FIGs. 10A-10B are block flow diagrams illustrating example processes for active filtering of charged particle signals and acceleration of negatively charged particles, respectively, in accordance with some embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been illustrated and described, it will be appreciated that various changes can be made therein without departing from the spirit and scope of the disclosure. In the forthcoming paragraphs, embodiments of a charged particle beam system, components, and techniques for protecting charged particle detectors are described. Embodiments of the present disclosure focus on electron microscopy and microanalysis and related systems in the interest of simplicity of description. To that end, embodiments are not limited to such systems, but rather are contemplated for charged particle beam systems where conventional techniques for detecting secondary charged particles are complicated by a multiplicity of primary charged particle beams and/or for samples that are ill-suited for approaches involving a bias voltage being applied to the sample surface. Similarly, while embodiments of the present disclosure focus on electron microscopy, and dual-beam systems in particular, additional and/or alternative systems are contemplated, including but not limited to focused ion beam systems, laser-ablation systems, or the like.

Embodiments of the present disclosure include systems, methods, algorithms, and non-transitory media storing machine-readable instructions for protecting a charged particle detector against damage induced by incident particles, including energetic and/or charged particles. In an illustrative example, a filter can include a frame and a membrane of carbon material, coupled with the frame. The membrane can define a first surface, a second surface opposing the first surface, and an aperture extending through the membrane from the first surface to the second surface. The frame can be configured to couple with a charged particle detector disposed in a charged particle beam column, the charged particle detector defining an absorption surface oriented toward the first surface. The filter can be configured to shield the absorption surface from particles incident on the second surface. The particles can include electrons, ions, or photons.

The following detailed description focuses on embodiments of charged particle beam systems including a focused ion beam source, but it is contemplated that additional and/or alternative instrument systems can be improved through the use of the techniques described. In an illustrative example, instrument systems of the present disclosure can include laser systems configured to ablate samples, systems configured for electron beam-induced removal of sample material, or the like. To that end, embodiments of the present disclosure can improve performance, stability, and lifetime of particle detectors, at least in part by shielding detector surfaces from incident particles, while also serving as a variable energy filter and/or collector for charged particles, based at least in part on application of a bias voltage.

FIG. 1 is a schematic diagram illustrating an example charged particle beam system 100, in accordance with some embodiments of the present disclosure. The example system 100 includes an electron source 105, an electron beam column 107, an ion source 110, a focused ion beam ("FIB") column 111, a gas injection system ("GIS") 115, a chamber 120, and a sample stage 125. The electron beam column 107 is illustrated as a scanning electron microscope (SEM) column, such that the example system 100 corresponds to a dual beam FIB-SEM system. The electron beam column 107, the FIB column 111, and the GIS 115 are illustrated as being operably coupled with the chamber 120, with the electron beam column 107 defining a first beam axis A and the FIB column 111 defining a second beam axis B. The axes A and B are illustrated converging onto a region of a sample 130, with the GIS 115 oriented toward the region of the sample 130 and configured to direct a gas stream including a precursor into the chamber 120. Advantageously, while axes A and B can also be oriented toward different location, convergence permits the SEM system to image the region of the sample being processed by the FIB.

The electron source 105 can include one or more emitters configured to generate electrons and to direct the electrons into the electron beam column 107. The emitters can include thermionic emitters, Schottky emitters, field-emission source emitters, or combinations thereof, operably coupled to power systems configured to apply a high-voltage (e.g., on the order of kilovolts to hundreds of kilovolts) to an emission region of the emitter material. For example, the electron source 105 can include a lanthanum hexaboride (LaB₆) emitter crystal to which a high electrical potential is applied to elicit the emission of electrons from a tip of the emitter crystal. In this way, a beam of electrons can be directed into the electron beam column.

The electron beam column 107 includes electromagnetic optics (e.g., electrostatic lenses, electromagnetic lenses, monochromators, etc.) and apertures configured to shape, focus, defocus, and direct the beam of electrons such that the beam is focused onto the sample 130, in accordance with a set of operating parameters. The operating parameters can include a beam current, a beam energy (e.g., in volts, in electron volts, or the like), a magnification parameter, a scan pattern, a dwell time, and/or one or more pulse parameters. In this way, the example system 100 can function as an SEM to image portions of the sample 130 and/or can be used for e-beam assisted deposition and/or removal of material onto the sample 130 (e.g., in coordination with the GIS 115).

In an illustrative example, the beam energy of an electron beam can be from about 10 eV to about 70 keV, including subranges, fractions, or interpolations thereof. Beam energies below about 1 keV can correspond with reduced pattern fidelity, while beam energies above about 50 keV can reduce the secondary electron yield below a level at which deposition can be impaired significantly or negligible. To that end, precursor decomposition and deposition reactions can be mediated by secondary electrons emitted from the sample 130, which are characterized by lower energies than the primary electrons of the beam (e.g., at about 50 eV or less). In this way, the beam energy can be selected at least in part based on the secondary electron emission function of the material of the sample 130, which can depend at least in part on the beam energy, for imaging purposes, to reduce damage to the sample, and/or to promote deposition.

The ion source 110 can include one or more components configured to generate a beam of ions and to direct the ions into the FIB column 111. The ions can include metal ions and/or nonmetal ions (e.g., noble gas, halogen, oxygen, nitrogen, or the like). To that end, the ion source 110 can include a plasma source (e.g., an inductively coupled plasma source) and/or a metal ion source (e.g., a liquid-metal ion source). As with the electron beam column 107, the FIB column can include electromagnetic optics (e.g., electrostatic lenses, electromagnetic lenses, monochromators, etc.) and apertures configured to shape, focus, defocus, and direct the beam of ion such that the beam is focused onto the sample 130, in accordance with a set of operating parameters. The operating parameters of the FIB components of the example system 100 can include a beam current, a beam energy (e.g., in volts, in electron volts, or the like), a magnification parameter, a scan pattern, a dwell time, and/or one or more pulse parameters. In this way, the example system 100 can function as a FIB to remove portions of the sample 130 and/or can be used for ion-beam assisted deposition of material onto the sample 130 (e.g., in coordination with the GIS 115).

Analogous to the energies described in reference to the electron beam, above, the ion beam energy can be selected (e.g., by a user, by an algorithm initiated by a user, and/or automatically without user intervention) such that the beam delivers enough energy for beam-induced deposition and/or removal to occur, but not such that the beam degrades the sample or degrades the precursor without forming deposited material layers on the sample 130 (e.g., as part of patterning). In some embodiments, additional and/or alternative precursor decomposition mechanisms (e.g., surface activation and/or secondary electron reemission) can be used as a mechanism for deposition/removal of sample material, thereby allowing the ion beam energy to be determined based at least in part on a relationship between beam energy, sample material properties, and the energetic characteristics of the precursor deposition reaction mechanism. Advantageously, ion beam-induced deposition and/or removal can elicit relatively high yields, in comparison to electron beam-induced deposition, based at least in part on the combined effect of multiple energy transfer pathways.

The GIS 115 includes constituent elements that together permit the GIS 115 to generate a gas stream including a precursor and to direct the gas stream into the chamber. The components of the GIS 115 can include a carrier gas inlet, a nozzle 119, and a conduit fluidically coupling the nozzle 119 and a precursor reservoir 117. The precursor reservoir 117 can include a substantially non-reactive container (e.g., a ceramic crucible, PTFE enclosure, a non-reactive metal or alloy, or the like) that is at least partially exposed to the conduit. In this way, vapor generated from a precursor disposed in the precursor reservoir 117 can be directed toward the nozzle and into the chamber (e.g., by pressure-driven flow induced by a pressure gradient relative to the vacuum of the chamber). In some embodiments, the GIS 115 includes a carrier gas inlet, fluidically coupled with the nozzle 119 via the conduit. In this way, the precursor can be entrained in a flow of carrier gas and directed toward the nozzle and into the chamber. Additionally and/or alternatively, the precursor can include a gas at standard conditions and can be introduced to the GIS 115 via a gas inlet provided as part of the GIS 115. In some embodiments, a carrier gas is omitted, and the precursor vapor is directed toward a sample position by pressure-driven flow induced by expansion of the vapor in the GIS 115.

In an illustrative example, the precursor can be or include a material that is a solid at standard temperature and pressure and at least partially vaporizes or sublimates. To that end, the GIS 115 can include a heating circuit that is thermally coupled with the precursor reservoir and configured to heat the precursor to within a range of temperatures that elicits at least partial vaporization. The temperature can be selected based at least in part on a vapor pressure estimate for the precursor, as part of controlling the composition of the gas stream entering the chamber. Such estimates can be determined using empirically derived heuristics for a given charged particle beam system and/or can be derived using thermodynamic first principles. In some cases, the temperature and flowrate can be selected based at least in part on an operational window determined from experimental calibration of a given charged particle beam system (e.g., for a given sample material and precursor material).

The chamber 120 can be configured to maintain a controlled environment in the vicinity of the sample 130. For example, the environment can be a relatively low base pressure with a fraction of precursor introduced via the GIS 115, and/or can include a fraction of one or more other gases (e.g., in environmental microscopy).

The operation of one or more components of the example system 100 can be coordinated by control circuitry, in accordance with machine-executable instructions (e.g., software, firmware, etc.) that can be stored in machine-readable storage media and/or received from external systems via wired and/or wireless communication techniques (e.g., over a WiFi or Bluetooth link). To that end, components of the example system can be automated (e.g., operating without human intervention), pseudo-automated (e.g., operating with limited human intervention to initiate operations, analyze output and confirm, or the like), or manually operated (e.g., where individual operations of the example system 100 are performed by a human user).

In an illustrative example, the sample stage 125 can be mechanically coupled with automated stage controls 127 that permit the sample 130 to be reversibly tilted relative to the beam axes A and B, such that the surface of the sample is substantially normal to a given beam axis during operation of the corresponding charged particle beam source. In this way, the operation of a given beam source can be coordinated with the operation of the stage controls 127. Similarly, the operation of the GIS 115 can be coordinated with the operation of the stage controls 127 and a given beam source (e.g., the electron beam source 105 and column 107).

Embodiments of the present disclosure can omit one or more components of example system 100. For example, one or more of the sources 105 and 110 and/or columns 107 and 111 can be omitted. In an illustrative example, an SEM system can be configured to perform operations of the beam-induced deposition processes of the present disclosure. Similarly, a system other than a dual-beam FIB-SEM (e.g., a FIB system for which two or more beam axes are not convergently trained on a given region of the sample 130, a laser-SEM, or the like) can include the GIS 115 oriented to be convergent with the second beam axis B.

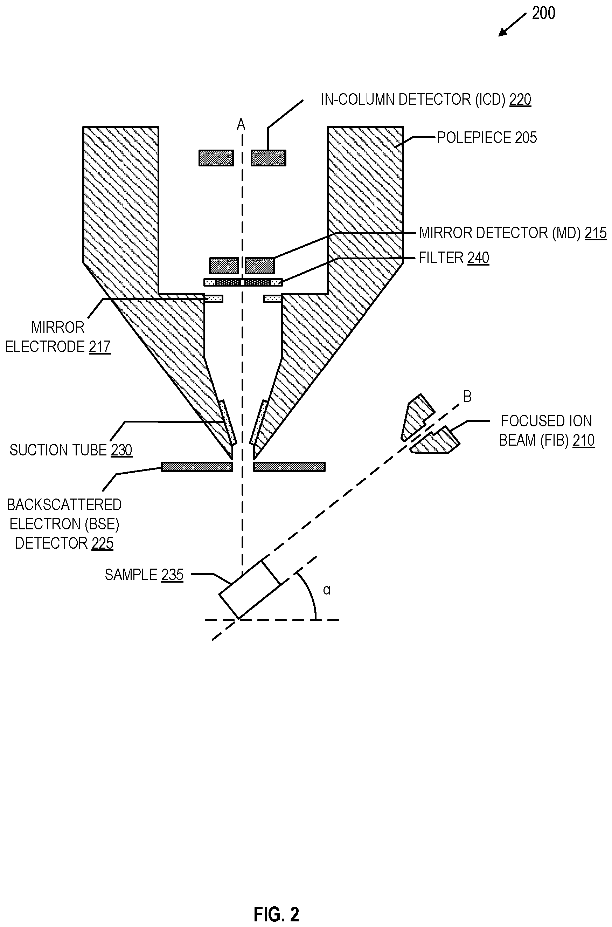

**FIG. 2** is a schematic diagram of a detail of the example system 100 of FIG. 1, in accordance with some embodiments of the present disclosure. Example system 200 is simplified, relative to example system 100 of FIG. 1, to focus description on detector components of the SEM system and omits optics, sources, vacuum system, and sample handling aspects. Example system 200 includes a polepiece 205, a FIB system 210, detectors including a mirror detector (MD) 215, an in-column detector (ICD) 220, and a backscattered electron detector (BSE) 225, electrodes including a mirror electrode 217 and a suction tube 230. Example system 200 is a convergent dual-beam configuration, with the electron beam system oriented along a first axis A and the ion beam system oriented along a second axis B, oriented relative to the first axis A at an angle α, the axes converging to the position of a sample 235. The example system 200 also includes a filter 240.

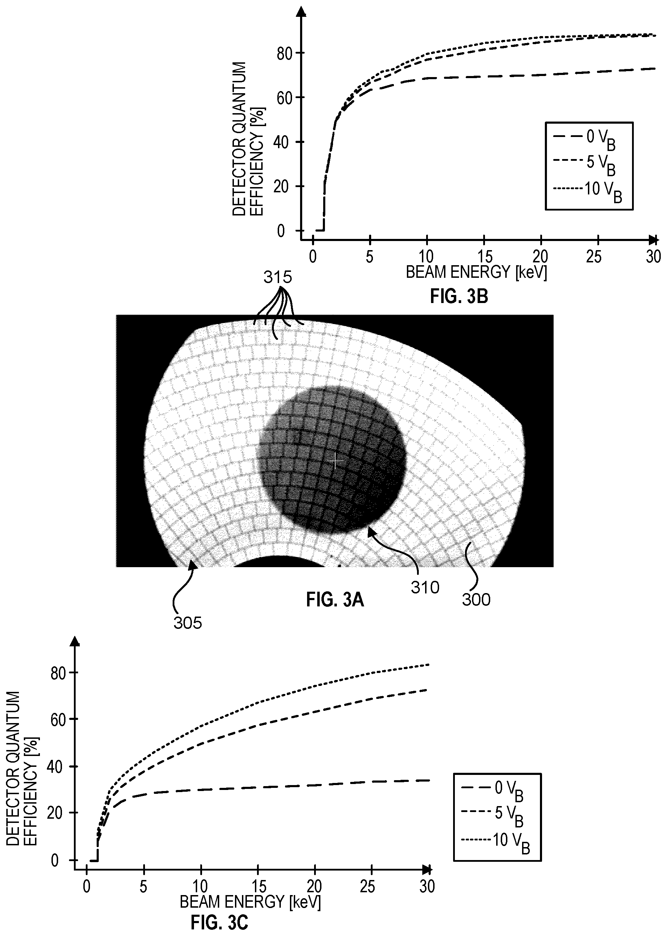

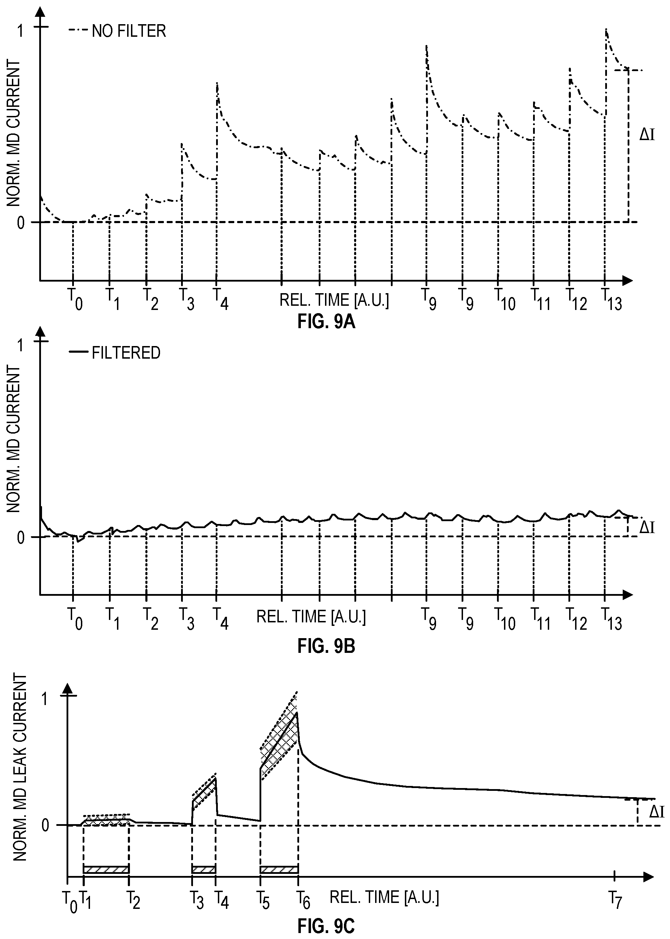

As described in more detail in reference to FIGs. 3A-3C, charged particle beam processing of the sample 235 (e.g., by electron beams, ion beams, beam-induced chemistry, etc.) can generate secondary particles, such as secondary electrons, secondary ions, ablated material, photons, or the like. A portion of incident primary particles (e.g., electrons and/or ions of the respective beams) can be scattered back toward the polepiece 205 and/or toward the FIB 210. In some cases, the particles can enter the pole piece and impinge on the internal components and detectors of the polepiece 205, such as the MD 215. The filter 240 can be disposed in the polepiece 205 to protect the MD 215 from damage by incident particles, as described in more detail in reference to FIGs. 9A-9C.

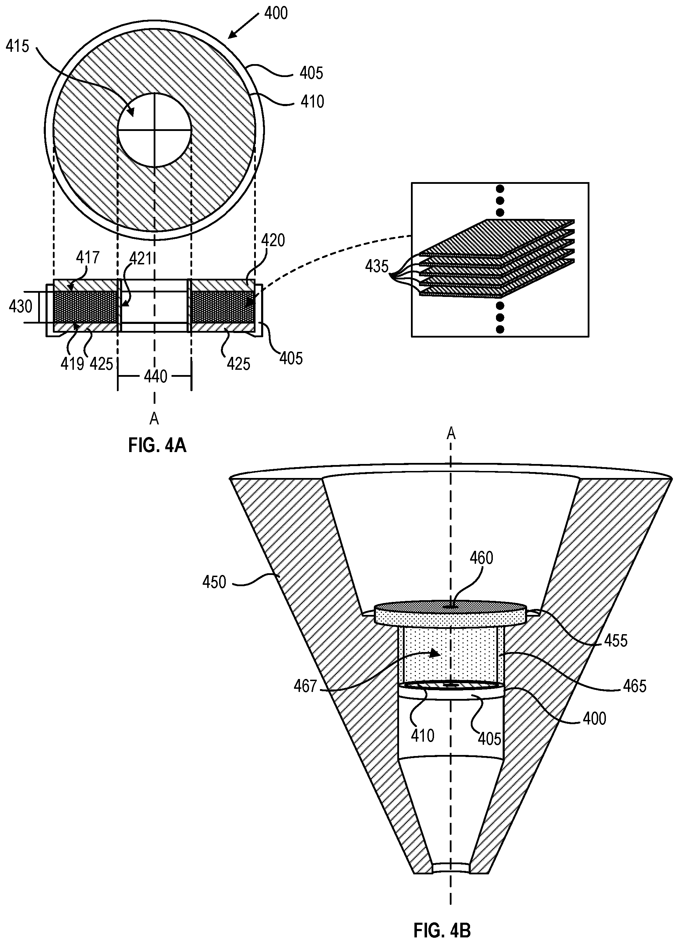

The filter 240 can be disposed along the first axis A between the mirror electrode 217 and the MD 215, as illustrated, but can additionally and/or alternatively can be disposed between the mirror electrode 217 and the suction tube 230. To that end, example system 200 can include a filter 240 at additional and/or alternative locations, such as between the MD 215 and the ICD 220, between the sample 235 and the BSE detector 225, etc. As described in more detail in reference to FIGs. 4A-5, the filter can be disposed in proximity to an absorption surface of the MD 215, can be coupled with the mirror electrode 217, and/or can be external to the mirror electrode 217. Each configuration offers different advantages, as described below in reference to FIGs. 4A-5.

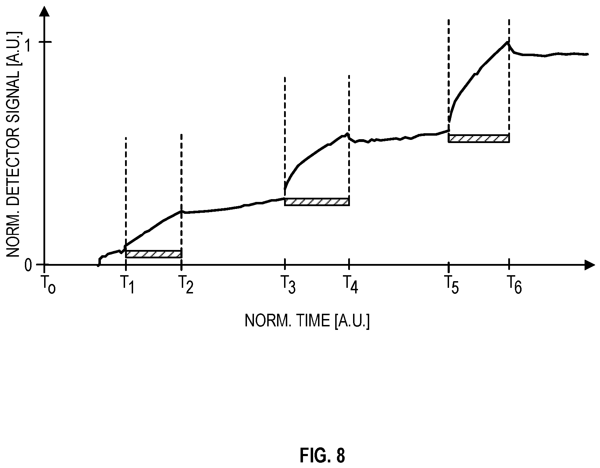

Particle induced damage, such as ion implantation in a solid state detector can modify the band gap of the detector, reduce the quantum efficiency of the detector, or increase the detector dark current (also referred to as the detector leak current), as described in more detail in reference to FIGs. 8-9C. Advantageously, the filter 240 can be configured to absorb, deflect, reflect, or otherwise prevent particles from reaching one or more detectors. In this way, the filter 240 can improve the robustness of the detector(s) of the systems of the present disclosure and, as described in more detail in reference to FIGs. 10A-10B can also serve as an energy selective filter for secondary electrons and/or as an accelerator for secondary electrons while also rejecting ions.

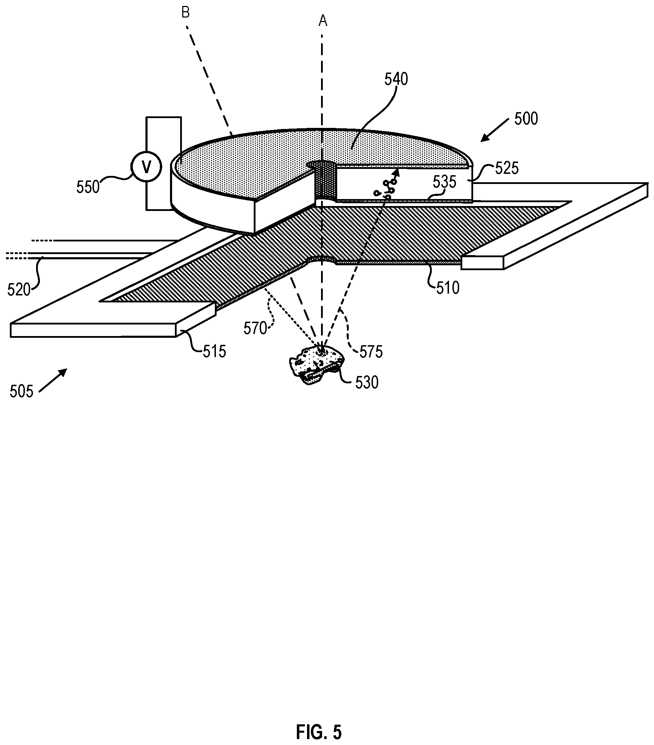

**FIG. 3A** is an electron microscope image of a solid state detector 300 surface including undamaged portions 305 and damaged portions 310, in accordance with some embodiments of the present disclosure. The detector 300 pictured is configured to generate a current signal resulting from incident energetic particles, as described in more detail in reference to FIG. 4B and FIG. 5. In the image, the undamaged portions 305 appear bright and the damage portions 310 appear dark. The damaged portions 310 result from exposure to a reflected ion beam that was backscattered from a sample (e.g., sample 130 of FIG. 1 or sample 235 of FIG. 2) as well as sputtered material ejected from the sample. In this context, "damaged" refers to impaired performance of the detector 300 that results from incident ions and/or other energetic particles affecting the electronic properties of the detector 300 (e.g., ion implantation into the material and/or deposition of energy that induces dopant migration). This can make the affected portions less sensitive to incident particles. This effect is illustrated in data plots in FIGs. 3B-3C. The detector is overlaid with a grid of material that forms substantially rectangular regions 315 of the surface. In the example of the detector of FIG. 3A, the regions 315 are part of a single active layer, of which a portion has been damaged. In some embodiments, however, a pixelated detector can be used, such that a subset of pixels in the pixelated detector can be damaged.

To that end, **FIG. 3B** is a plot of example detector quantum efficiency data for an undamaged portion 305 of the solid state detector of FIG. 3A, in accordance with some embodiments of the present disclosure. The horizontal, x-axis of FIG. 3B represents average beam energy, in units of kiloelectronvolts (keV), while the vertical, y-axis, represents the quantum efficiency of the undamaged portion 305 of the example detector 300. The plot includes data for three applied bias voltages, zero volts (in long-dashed lines "--"), five volts (in short-dashed lines "--"), and ten volts (in dotted lines "--"). as described in more detail in reference to FIG. 4B, the bias voltage can be applied to a conductive layer on or near an absorption surface of the detector. In the context of FIG. 3B, a bias voltage can reduce the likelihood of electron-hole recombination in solid state detectors, thereby increasing the detector quantum efficiency, as illustrated in the trend toward higher efficiency values at average beam energy above about 2 keV in FIG. 3B.

In contrast, **FIG. 3C** is a plot of example detector quantum efficiency data for the damaged portion 310 of the solid state detector of FIG. 3A, in accordance with some embodiments of the present disclosure. As in FIG. 3B, the axes represent average beam energy (X) plotted against detector quantum efficiency (Y). Unlike the data in FIG. 3B, however, the impact of charged particle damage is revealed in the significant decrease in efficiency through the range of average energy from 0 keV to about 30 keV. For example, at about 5 keV, the quantum efficiency of the damaged detector is about half that of the undamaged detector. Similarly, at 20 keV, the quantum efficiency of the damaged detector is about half that of the undamaged detector at zero applied bias voltage, and about 25% and about 16% lower at 5 V and 10 V applied bias, respectively.

**FIG. 4A** is a schematic diagram of an example particle filter 400, in accordance with some embodiments of the present disclosure. The example filter 400 is an example of the filter 240 described in reference to FIG. 2. As such, example filter 400 includes a retaining element 405 and a membrane 410. The example filter 400 defines an aperture 415 through the membrane 410, which can also be defined at least partially in and/or through the retaining element 405. The example filter 400 can also include a conductive layer 420 disposed over at least a portion of the membrane 410. The membrane can define a first surface 417 and a second surface 419, opposing the first surface 417. The membrane 410 can have a thickness 430, such that the membrane 410 also defines an inner surface 421 over which the conductive layer can be disposed at least partially. At least a portion of the membrane 410 can be supported by a supporting element 425.

The retaining element 405 can be configured to be incorporated into a scanning electron microscope (SEM), as described in more detail in reference to FIG. 2 and FIG. 4B-5. The retaining element 405 can include mechanical fittings, couplings, and/or features corresponding to a given SEM system. For example, in a mirror detector (e.g., MD 215 of FIG. 2) the retaining element 405 can include one or more through-holes corresponding to a position of corresponding mounting points in or on a pole piece of the SEM system (e.g., polepiece 109 of FIG. 1), facilitating mechanical coupling of the retaining element 405 within the SEM. The pole piece can be differently configured in different SEM systems. For example, some manufactures can omit some features in favor of others, such that the configuration of the retaining element 405 can be based at least in part on the charged particle microscope into which the retaining element 405 is to be incorporated. Similarly, the retaining element 405 can be configured for mechanical coupling with a support, as described in more detail in reference to FIG. 5, which can permit the example filter 400 to be withdrawn and or put into place and oriented toward a sample and/or beam target (e.g., sample 130 of FIG. 1). In this way, the retaining element 405 can be configured to tilt and/or linearly translate (e.g., provided with multiple degrees of freedom).

The membrane 410 can be mechanically coupled with the retaining element 405, for example, by adhesive, retaining clips, tensioners, screws, or the like. The second surface 419 is illustrated as opposing the first surface 417, but can also be in a different configuration. The conducting layer 420 can be disposed overlying the first surface 417 or at least a portion of the first surface 417. In some embodiments, the conducting layer 420 can be or include a metal, a transparent conductive material, a conductive carbon film, and/or other conductive materials compatible with chemical vapor deposition, physical vapor deposition, epitaxy, or other techniques used to deposit conductive materials with controlled purity and thickness on the order of tens to hundreds of nanometers. To that end, first conducting layer 420 can be characterized by a substantially uniform thickness (e.g., limited by and within tolerances of the fabrication method) below a threshold at which the conductive material impairs the performance of the underlying detector. The first conducting layer 420 can be disposed as a patterned film or patterned layer over the acceptor layer (e.g., in the shape of a grid or other geometric configuration) used to distribute the electrostatic field on the surface. In this case, the first surface 417 will not covered by material of 420 in the meshes of the grid, which may improve detection of some of the incoming particles. In some embodiments, the membrane 410 is conductive (e.g., including at least some content of electrically conducting carbon nanotubes), such that a conductive contact between the membrane 410 and the retaining element 405 can be used to apply a bias to the filter 400 (e.g., in the absence of a conducting layer 420).

In some embodiments, membrane 410 and/or retaining element 405 define the aperture 415. The aperture can be included in the example filter 400 to permit a beam of charged particles to pass through the retaining element 405 and/or the membrane 410. While the nominal diameter of the beam of electrons can be on the order of tens of nanometers, electromagnetic interaction between the membrane and the beam of electrons and the extent of the scan angle can influence a value of a diameter 440 below which the beam is affected by the presence of the filter 400 (e.g., the beam is deformed, is at least partially blocked, or interferes with the membrane 410). For at least these reasons, the aperture 415 can be characterized by a diameter 440 from about 0.1 mm to about 10 mm, including sub-ranges, fractions, and interpolations thereof. For example, the diameter can be about 0.1 mm, about 0.2 mm, about 0.3 mm, about 0.4 mm, about 0.5 mm, about 0.6 mm, about 0.7 mm, about 0.8 mm, about 0.9 mm, about 1.0 mm, about 2.0 mm, about 3.0 mm, about 4.0 mm, about 5.0 mm, about 6.0 mm, about 7.0 mm, about 8.0 mm, about 9.0 mm, or about 10.0 mm including subranges, fractions, and interpolations thereof.

The angular distribution of particles relative to the sample surface (e.g., as described in reference to FIGs. 1-2) can serve as constraints on the diameter 440 of the aperture 415. For example, in the case of an x-ray detector, x-ray flux increases nearer to the beam axis A, such that filter 400 performance improves in general for smaller values of the diameter 440. In contrast, interference between the filter 400 and the beam of electrons can impair the functioning of the charged particle microscope system and/or the filter 400. In this way, the diameter 440 can be limited by a lower threshold below which the filter 400 interferes with the operation of the charged particle microscope and by a general design consideration to reduce the diameter 440.

In some embodiments, the conducting layer 420 (e.g., gold, aluminum, etc.) can be disposed overlying the internal surface 421 of the aperture 415. The conducting film 420 can be electronically coupled with a bias circuit, configured to apply a bias voltage (e.g., the bias voltage VB illustrated in FIGs. 3A-3B). As described in reference to FIGs. 10A-10B, the bias voltage can serve to filter particles by charge and/or by energy, and can improve the performance of the detector by attracting charged particles toward a detector. For example, bias circuitry can be configured to apply a bias voltage across the acceptor layer membrane 410 having a magnitude from about 0 V to about 5 kV, including sub-ranges, fractions, and interpolations thereof. Larger magnitudes of the bias voltage increase the likelihood that the charged particle filter will interfere with the operation of the charged particle microscope (e.g., by forming local discharges or by deflecting and/or deforming the beam of primary electrons oriented along axis A). In some embodiments, the internal surface 421 is provided with an isolated conducting surface, such that the internal surface 421 can be electrically grounded or held at a potential of another part of the column. In this way, lensing effects of a bias on the internal surface 421 can be avoided. To that end, one or more interstitial layers of nonconducting material can be disposed between the isolated conducting surface and the internal surface 421 (e.g., where the membrane 410 is conductive and a short circuit between the grounded internal surface and the biased first surface is to be avoided).

The supporting element 425 can be coupled with the membrane 410 over at least a portion of the second surface 419. In some embodiments, the supporting element 425 is a grid over which the membrane 410 is disposed. The grid can be or include a metal or other material that can be selected for its material and/or chemical properties (e.g., compatibility with charged particle microscopy and microanalysis, compatibility with vacuum, tensile and other mechanical properties, etc.). The supporting element 425 can also be a thin foil or other form of material that, when coupled with the membrane 410, provides structural support the membrane 410 or otherwise improves the performance of the membrane 410 as a filter. For example, the supporting element 425 can be or include the same material as the conducting film 420, disposed on the second surface 419 at a thickness that provides structural support to the membrane 410 without interfering with the transmission of energetic particles through the membrane (e.g., electrons above a given energy, x-ray photons, etc.). As described in more detail in reference to FIG. 5, some embodiments of the present disclosure omit the supporting element 425 in favor of a freestanding membrane 410.

The example filter 400 is shown in an annular form factor. Embodiments of the present disclosure include additional and/or alternative form factors, including but not limited to rectangular form factors or other polygonal form factors. Similarly, the schematic diagram of FIG. 4A is not intended to limit the geometric arrangement of constituent elements of example filter 400. Example filter 400 is illustrated in a concentric configuration, with aperture 415 being substantially centered about the axis A. In some embodiments, however, the aperture 415 can be offset relative to a geometric center of the membrane 410, for example, where the membrane 410 is shaped to protect a detector surface from particles emanating from a specific angle relative to the beam axis A and/or across a range of angles that are not rotationally symmetrical about the beam axis A.

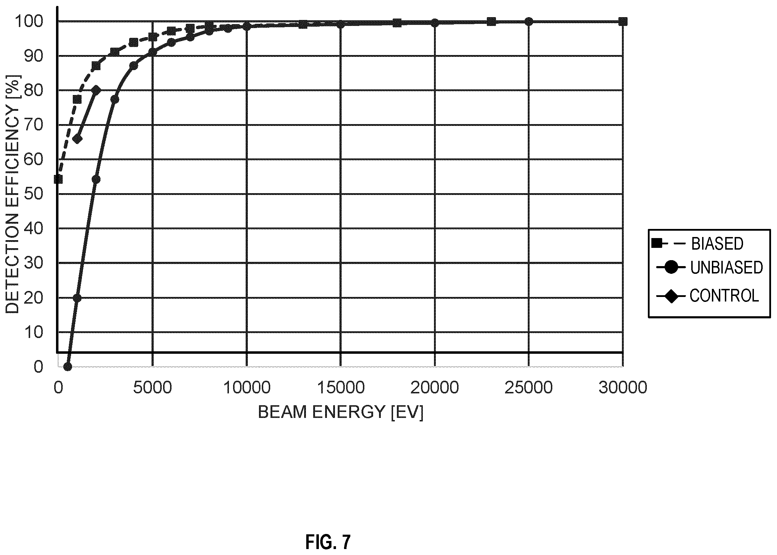

The membrane 410 can include materials that exhibit energy-dependent transmissivity to energetic particles. As described in more detail in reference to FIG. 7, selective transmissivity refers to the membrane 410 permitting at least a portion of incident particles of a given energy to pass through the filter 400, while absorbing, reflecting, or otherwise blocking the transmission of other forms of incident particles, such as relatively low-energy photons and relatively massive charged particles (e.g., electrons, ions, etc.) below a given energy. The membrane 410 material can block all or substantially all photons and charged particles below respective threshold energies. For example, the membrane 410 can absorb, reflect, or otherwise block substantially all electrons having an energy of about 7.8 keV or less, as described in more detail in reference to FIG. 7. In another example, a membrane 410 having a thickness of about 500 nm can block substantially all electrons below 700 eV energy and substantially all ions, but can be relatively transmissive across the visible spectrum for photons.

In some embodiments, the threshold energy can be selected based at least in part on the thickness of the filter and/or the density of the filter as parameters. For example, a filter with a thickness of about 2 um can block incident electrons having an energy below about 2.5 keV. While lower than 7.8 keV, the thickness dependency of filter performance permits tuning of operating conditions, as described in more detail in reference to FIGs. 4A-7. As described above, a relatively thinner membrane can be characterized by higher transmission fraction for electrons and photons, while retaining low transmissivity to ions and sputtered material. For example, single layer graphene can transmit electrons at an energy of about 20 eV and can be substantially transparent to visible and UV photons. Further, the threshold energy can depend at least in part on the composition of the membrane 410. For example, a membrane 410 including multiwall carbon nanotubes can be characterized by a higher threshold energy, relative to a membrane 410 including single wall carbon nanotubes. Similarly, a membrane 410 having a relatively higher density of nanotubes per unit surface area can be characterized by a higher threshold energy than a membrane 410 having a relatively lower density of nanotubes per unit surface area.

In an illustrative embodiment, an areal density is defined as the mass of membrane 410 material per unit surface area (e.g., square centimeters). Characteristics of the membrane 410 can be described and/or related via the areal density, based at least in part on characteristic volumetric properties including volumetric density (e.g., mass per volume) of the carbon material and/or void percentage of the membrane (e.g., average proportion of empty space in the membrane). In some embodiments, the volumetric density of the carbon material is from about 0.11 g/cm³ to about 1.1 g/cm³, including sub-ranges fractions, and interpolations thereof. In some embodiments, transparency and thickness are inversely related. For example, for a given areal density, a membrane thickness of about 1.32 µm can correspond to a transmissivity at 550 nm of about 3.5 %, while a membrane thickness of about 2.64 µm can correspond to a transmissivity of about 0.12 %. In this way, for a given membrane, both the thickness and the transparency of the membrane can be refenced to the areal density. For example, the areal density can be from about 0.1 µg/cm² to about 330 mg/cm², including sub-ranges, fractions, and interpolations thereof, permitting the dimensions, number of layers, and individual layer thickness of the membrane 410 to be determined based at least in part on a balance between transparency and dimensional/space constraints.

In some embodiments, the membrane 410 includes a carbonaceous material. The carbonaceous material can include carbon nanotube materials. The carbon nanotube materials can include single-walled nanotubes, double-walled nanotubes, multi-walled nanotubes, and/or mixtures thereof. The carbonaceous material can include carbon nanofiber, nano-bamboo, other forms of sp² hybridized carbon, sp³ hybridized carbon, and/or mixtures thereof (e.g., a combination of graphitic and amorphous carbon). Nanotubes, nano-bamboo, and/or nanofibers can be oriented along a one or more in-plane directions and/or can be randomly oriented. For example, the membrane 410 can include layer(s) in which the carbon nanotubes making up a carbon nanotube felt are substantially aligned with an orientation direction. Different layers can be oriented in the same direction or in different direction(s). While substantially aligned with an orientation direction over a given layer and/or membrane 410, individual nanotubes, nanofibers, etc., can exhibit tortuosity (e.g., curving, angulation/kinking, looping, and/or spiral twisting segments) such that segment(s) of a given nanotube, nanofiber, etc., can be oriented away from the orientation direction. Even so, a layer including carbon nanomaterial can be substantially planar over a macroscopic length-scale (e.g., in a nonwoven nanotube felt or in a carbon nanofiber cloth). The membrane 410 can further include metal, ceramic, and/or nitride materials, for example, as a coating, inclusion, or other form that does not substantially limit the transmissivity of the filter 400.The membrane 410 can be electrically coupled to a potential (e.g., a ground potential, a positive bias, a negative bias). Advantageously, electrically grounding the membrane 410 can improve the absorption and/or neutralization of charged particles (e.g., absorption of ions and/or surface recombination of ions), without significantly affecting the performance of other components of the charged particle microscope system in which the filter 400 is disposed.

The membrane 410 can have a thickness 430 on the order of about 10 nm to about 10 um (e.g., from about 10 nm to about 99 um), including subranges (e.g., from about 0.5 um to about 30 um), fractions, and interpolations thereof. The membrane 410 can include multiple layers 435 of material. For example, the layers 435 can be or include carbon nanotube material, being from about 3 nm thick to about 1 um thick, individually, including subranges, fractions, and interpolations thereof. In an example, each layer 435 can have a thickness of about 0.4 um, such that a membrane 410 having two layers 435 of carbon nanotube material can be about .8 um thick and a membrane having 25 layers of carbon nanotube material can be about 10 um thick. Without being bound to a particular physical phenomenon or mechanism, the filter 400 can have a thickness-dependent transmissivity, based at least in part on the absorbance of each constituent layer 435. In this way, the membrane 410 can include a number of layers 435 that permits the filter 400 to absorb substantially all incident infrared, visible, and ultraviolet photons and/or ions, while permitting the transmission of a significant portion of x-rays and/or electrons having an energy above a given threshold.

Each layer 435 can have a photon absorbance from about 1% to about 90% (e.g. as measured at 525 nm). In the example of 25 layers of carbon nanotube material, where each layer has an absorbance of about 40% at 525 nm, the overall absorption factor of the membrane 410 for photons at 525 nm can be about 1x10⁻⁹. In the example of a membrane 410 having a thickness of about 2 um, the transmissivity of Li Kα (55eV) x-rays 275 can be about 23%. In this way, the filter 400 can improve performance of a detector by protecting the acceptor layer from incident particles that would otherwise reduce the quantum efficiency of the detector, while permitting a substantial portion of particles of interest (e.g., x-ray photons, electrons, etc.) to reach the detector.

**FIG. 4B** is a schematic diagram of an example polepiece 450, in accordance with some embodiments of the present disclosure. Example polepiece 450 includes the example filter 400 of FIG. 4A with membrane 410 and retaining element 405, as described in reference to FIG. 4A. The example polepiece 450 is an example of the polepieces of the present disclosure (e.g., polepiece 109 of FIG. 1, polepiece 205 of FIG. 2). To that end, example polepiece 450 includes a mirror detector 455, a mirror electrode 465, and can include the components described in reference to FIGs. 1-2, such as additional and/or alternative detectors, electrodes, etc., as well as other components (e.g., lens coils, apertures, or the like).

Without being bound to a particular physical mechanism or phenomenon, particle detectors of the present disclosure can be configured to generate electrical signals in response to incidence of energetic particles (e.g., electrons, x-rays, etc.) onto an absorption surface of an acceptor layer that, for solid state detectors, can include a doped semiconductor layer. As described in more detail in reference to FIG. 5, penetration of the energetic particles into the acceptor layer can generate electron-hole pairs that can be separated and driven to respective conducting layers by force of a bias voltage applied across the acceptor layer. Current measurement circuitry can be configured to integrate the current drawn from acceptor layer and/or returned to the ground or relative ground over a period of time (e.g., coordinated with the scan pattern of the SEM as part of imaging or for a defined exposure time for spot-mode analysis). The magnitude of the bias voltage can be based at least in part on the thickness of the acceptor layer, as an approach to improving detector efficiency (e.g., by reducing the probability of electron-hole recombination in the acceptor layer).

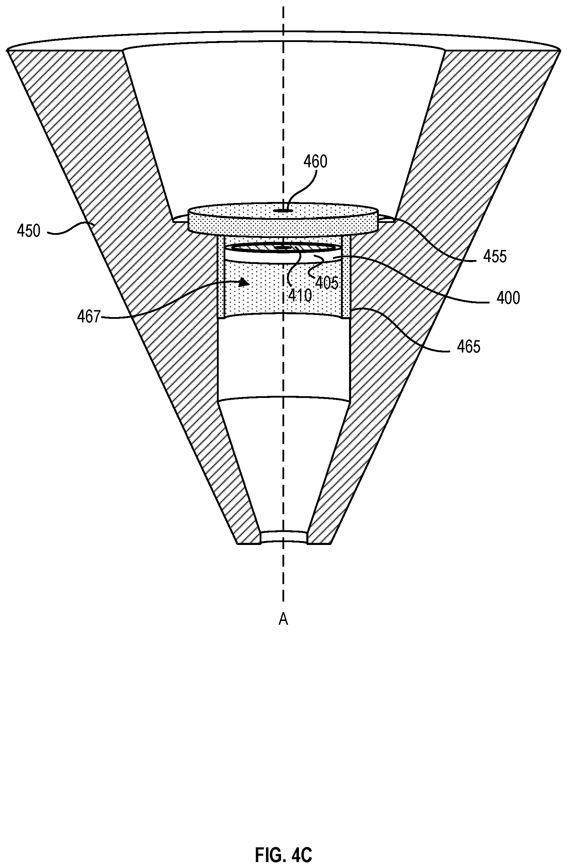

The detector 455, like example filter 400, can be configured to be incorporated into example charged particle system 100 of FIGs. 1-2. To that end, the detector 455 can define an aperture 460 that is substantially centered about the axis A. In some cases, the aperture 415 of the filter 400 and the aperture 460 of the detector 455 can be aligned, concentric (albeit at different positions on the axis A) and/or coextensive (e.g., having diameters that are substantially equal). In some embodiments, the filter 400 is coupled with the detector 455 via the mirror electrode 465. The filter 400 can also be coupled with the detector 455 with an offset (e.g., as illustrated in FIG. 4C), can be coupled with the polepiece 450 (e.g., external to the mirror electrode 465), can be disposed in the polepiece 450 between the detector 455 and the mirror electrode 465 (e.g., as illustrated in FIG. 2), and/or can be coupled with an internal surface 467 of the mirror detector (e.g., a surface oriented toward the axis A). Each of the different configurations described offer different functional advantages. For example, disposing the filter 400 between the mirror electrode 465 and the detector 455 can shield the portion of the column below the filter 400 from a bias potential applied to the filter 400. Further, separating the filter 400, detector 455, and mirror electrode 465 permits different respective bias potentials to be applied to each respective component. In another example, coupling the filter 400 with the mirror electrode can permit the filter 400 to carry the same bias potential and act as part of the mirror electrode to repel electrons having relatively low energy.

**FIG. 4C** is a schematic diagram of the example polepiece 450, in accordance with some embodiments of the present disclosure. The polepiece 450 is configured for incorporation in a charged particle beam instrument (e.g., a scanning electron microscope (SEM)).

The filter 400 is an example of the filters of the present disclosure (e.g., filter 240 of FIG. 2. The filter 400 and the detector 455 define respective apertures that are shaped to accommodate a beam of charged particles, oriented along the axis A. The coupling between the retaining element 405 of the filter 400 and the mirror electrode 455 can be facilitated by mechanical fastening, such as threading, groove and tongue, spring-clasps, set screws, or other approaches. In some embodiments, the filter 400 is disposed within the mirror electrode via a friction fitting and held in place against a substantially smooth and polished inner surface 467.

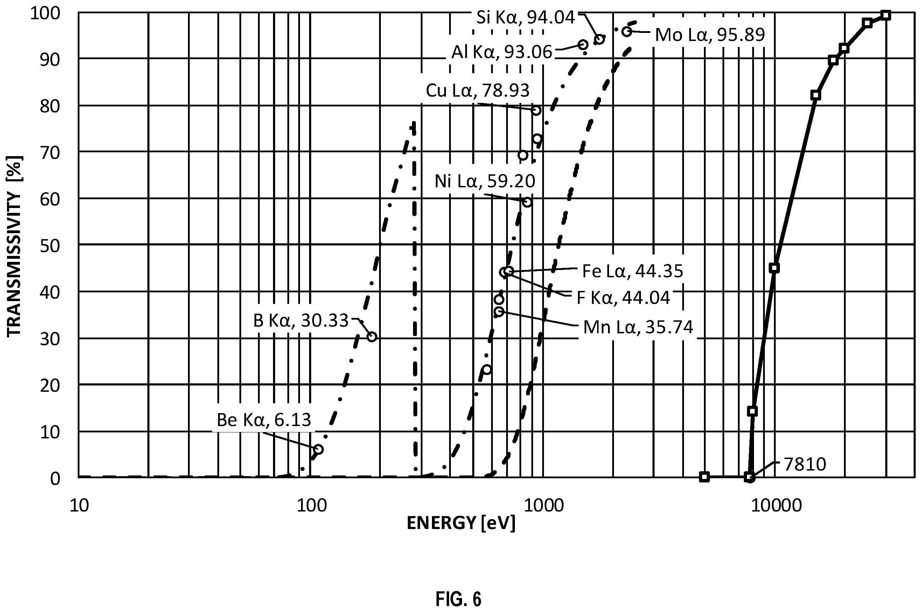

The membrane 410 of the filter 400 can be substantially freestanding across the span of the mirror electrode 455. As described in more detail in reference to FIG. 6, below, the retaining element 405 can serve as a frame across which the membrane 410 is held. A combination of material properties (e.g., young's modulus, flexural modulus, strength, geometric stiffness, etc.) of the bulk material (e.g., a composite of various materials that together exhibit an overall material property that can differ from the component materials) can permit the membrane 410 to be self-supporting across an inner distance between edges of the retaining element 405.

**FIG. 5** is a schematic diagram of an example detector 500, in accordance with some embodiments of the present disclosure. The example detector 500 can be an example of the detectors of the present disclosure (e.g., detectors 215, 220, or 225 of FIG. 2, detector 455 of FIGs. 4A-4B). The example detector 500 is disposed proximal to a filter 505 and is electronically coupled with electronic circuitry 550. The detector 500 defines an absorption surface 535, with one or more contacts 540 that are patterned on a surface of the detector 500 such that electron-hole pairs generated within an active layer 525 of the detector 500 are separated and drawn toward opposing contacts 540 by an bias voltage applied across the detector 500.

The filter 505 includes a membrane 510 in a frame 515. The frame can be coupled with a retention arm 520 by which the filter 505 can be positioned relative to the detector 500. In some embodiments, the filter 505 can be moved relative to the detector 500. As shown, the filter 505 is positioned between a sample 530 and the detector 500. In this way, the filter 505 can selectively absorb, reflect, or otherwise block incident particles 570 (e.g., ions, relatively low energy electrons, IR/VIS/UV photons, etc.), allowing a subset of the incident particles 575 to transit the membrane 510 (e.g., relatively high energy electrons, characteristic x-ray photons, etc.).

As described in more detail in reference to FIG. 4A, the membrane 510 can include multiple layers of filter material (e.g., carbon nanotube nonwoven felt). The frame 515 can be coupled with the membrane 510 over at least a portion of the periphery of the membrane 510. In this way, the frame 515 can mechanically support the membrane, permitting the membrane 510 to be substantially free standing over the region of the filter 505 that corresponds to the detector 500. As described in more detail in reference to FIG. 4A, the membrane 510 can be characterized by one or more material properties that permit the membrane 510 to maintain a structural integrity under the conditions of operation of a charged particle beam system (e.g., example system 100 of FIG. 1) and under exposure to incident particles 570 emanating from the sample 530, substantially without mechanical support over an interior portion of the membrane 510 nearer to the axis A and away from the frame 515.

In some embodiments, one or more portions of the frame 515 and/or retention arm 520 can be or include electrically conductive material. In this way, the frame 515 can be electrically coupled with the membrane 510, by which a bias voltage can be applied to the membrane 510. As described in more detail in reference to FIG. 10, a bias voltage, applied to the membrane 510 and/or the frame 515, can be used to accelerate/attract oppositely charged particles, to repel or decelerate like-charged particles, and/or to filter like-charged particles at or below a given threshold energy.

**FIG. 6** is a plot of example transmissivity data for multiple types of detectible signals, in accordance with some embodiments of the present disclosure. In the plot, the abscissa and ordinate plot transmissivity of the filter to x-rays (in dashed lines) and to electrons (in solid lines) against energy in electron volts. Transmissivity data for filters of the present disclosure are provided in hollow circles (∘) for x-ray data and in hollow squares (□) for electron data. The dash-dot line (- • -) provides a simulated x-ray transmissivity curve for filters of the present disclosure, while the dashed line (- - -) provides a simulated x-ray transmissivity curve for a conventional pure beryllium window used to shield solid state x-ray detectors.

The data in FIG. 6 illustrate that filters of the present disclosure do not inhibit the performance of x-ray photon detectors (e.g., silicon drift detectors). Further, detectors of the present disclosure can be substantially blind to electron flux, as evidenced by the transmissivity of the filter for which the data are shown being at or near zero percent for electrons having an energy equal to or below about 7.8 keV, corresponding to an energy greater than the Mo Lα x-ray line by almost two orders of magnitude. As described in more detail in reference to FIGs. 4A-5, the transmissivity of the filter material at a given energy can be based at least in part on dimensions of the filter membrane (e.g., membrane thickness 430 of FIG. 4A). In this way, the energy-selectivity of the filters of the present disclosure is given as a single example for a filter configured to absorb substantially all electrons below the energy of about 7.8 keV, but the numerical value of the threshold energy can be lower, for example, to facilitate the detection of electrons (e.g., in a mirror detector). Transmissivity of ions is not provided, because it is negligible or zero for the range of energies described in the plot of FIG. 6. **[INVENTORS: IS THIS ACCURATE?]**

For example, filters of the present disclosure can be configured to transmit at least a fraction of electrons across a range of energies greater than about 30 eV. Advantageously, filters of the present disclosure are substantially opaque to ultraviolet, visible, and/or infrared photons (e.g., photons), to ions, and to sputtered and/or ablated material. In this way, filters of the present disclosure can be used to improve for measurement of luminescent samples and/or heated samples, for which photon noise in detector data can be significant with current detector technology.

**FIG. 7** is a plot of example detection efficiency data as a function of beam energy, in accordance with some embodiments of the present disclosure. The data in FIG. 7 illustrate that the filters of the present disclosure (e.g., filter 240 of FIG. 2, filter 400 of FIGs. 4A-4B, filter 515 of FIG. 5, etc.) introduce an energy-dependent attenuation of detector efficiency (e.g., a reduction in detector efficiency relative to an unfiltered detector). Efficiency data for filtered detectors are provided in solid squares (▪) and solid circles (•) and in solid diamonds (□) for control data. The two sets of data with filter protected detectors represent biased detectors and unbiased detectors, respectively.

These data were collected using a calibrated electron source with a known beam current and a pure boron detector, permitting the direct comparison of the detector current with, and without, a filter membrane placed between the beam source and the detector surface. The data demonstrate that the filters of the present disclosure can protect solid state detectors with improved performance relative to the control at relatively low energy below about 2 keV, while also protecting the detector surface from damage described in reference to FIGs. 3A-3C. For example, between about 1 keV and about 2 keV, detectors of the present disclosure exhibit a detection efficiency that is from about 5% to about 15% higher with a filter and under an applied bias, relative to the control data presented. Further, with an applied positive bias, the detection efficiency of the detector was above 50% even at a minimal energy (e.g., less than 100 eV), demonstrating that the filter did not impose a lower limit to transmissivity when a surface bias is applied to the membrane and/or to the detector.

**FIG. 8** is a plot of example detector current data for multiple particles and detectors, in accordance with some embodiments of the present disclosure. The data in FIG. 8 illustrate an unfiltered detector signal over a sequence of exposures of a detector to ion radiation, resulting in damage to the detector surface, as described in more detail in reference to FIGs. 3A-3C. As shown, the normalized detector signal, on the vertical "Y" axis, does not return to an initial state (normalized to a value of zero at time of Tₒ). During a first period of exposure, between time T₁ and time T₂, the detector signal increases substantially monotonically with exposure time, after which the detector signal does not revert but rather remains elevated. The detector signal again increases, substantially monotonically, between time T₃ and time T₄, during which the detector surface is again exposed to ion radiation. This is repeated for a third exposure period between time T₅ and time T₆, after which the detector signal decreases slightly and remains elevated.

As would be understood, the elevated detector signal between time T₂ and time T₃ represents significant noise, which significantly impairs the performance of the detector during the same period. With the progressive nature of the effect, the sequence of ion radiation events can substantially reduce the sensitivity of a detector to electron signals, where leakage current can comprise a large portion of detector signal and overwhelm relatively small signals originating from incident electrons.. Advantageously, filters of the present disclosure, being substantially opaque to ions, can reduce or substantially eliminate the effect illustrated in the data of FIG. 8, as demonstrated in FIGs. 9A-9C.

**FIG. 9A** is a plot of example detector current data for an unfiltered solid state detector, in accordance with some embodiments of the present disclosure. The data were collected by exposing a mirror detector (e.g., MD 215 of FIG. 2) to a combined flux of secondary electrons and ions resulting from the exposure of a sample to a focused ion beam (FIB) at multiple instances, labeled at various times (T) on the horizontal "X" axis, with the resulting normalized detector current plotted on the vertical "Y" axis. At each instance, Tᵢ, the detector current increases significantly and discontinuously, showing an abrupt result of the influx of ions of the FIB reflected from the surface of the sample and toward the detector. As also described in reference to FIGs. 3A-3B and FIG. 8, the detector current does not revert to the initial value at time Tₒ, instead exhibiting a hysteresis effect attributable at least in part to the modification of the band structure of the detector cell. Over the course of 12 exposures to ions of the FIB, the detector current progressively increases, with asymptotic hysteresis to a higher value than what preceded the respective exposure. The result is an overall increase in the base, or "dark," current of the mirror detector, labeled ΔI.

**FIG. 9B** is a plot of example detector current data for a filtered solid state detector, in accordance with some embodiments of the present disclosure. The data of FIG. 9B were collected during the same set of exposures as in FIG. 9A, using a mirror detector that was protected against the flux of incident ions using a filter of the present disclosure, as described in more detail in reference to FIGs. 2-8. A marked difference is observed over the course of the 12 exposures, in particular in the relative magnitude of the increase of the detector current over time, ΔI, which is significantly smaller than that for the unprotected detector of FIG. 9A. While the current data in FIG. 9B do exhibit a semi-regular fluctuation, this was attributed to environmental changes with time by correlated measurement of system parameters and environmental conditions (e.g., ambient temperature). Advantageously, the data of FIG. 9B clearly demonstrate that filters of the present disclosure obviate the technical challenge described in reference to FIGs. 3A-3C, in particular, reducing the "damage" to detector cells resulting from ion flux during FIB processing of samples.

**FIG. 9C** is a plot of example detector leak current data for an unfiltered solid state detector, in accordance with the current art. The data reflect another advantage of the filters of the present disclosure by revealing the influence of ion exposure on the performance of an example mirror detector. In particular, the plot of FIG. 9C presents leakage current on the vertical, y-axis against time (relative to a reference time Tₒ) on the horizontal, x-axis. In this context, a leakage current refers to a current that flows through the detector circuit when the expected current is zero, associated with the detector being in an "off" state, or in the absence of a flux of particles incident on the detector surface.

The detector was exposed to three successive doses of ions reflected from a sample surface under exposure to a FIB, illustrated using a hatched region bounded by short dashes. During each successive exposure (e.g., T₁-T₂, T₃-T₄, T₅-T₆) the leakage current increases monotonically, both within a given exposure and between the exposures. In particular, the leakage current appears to return to the value at the end of the preceding exposure period at the onset of the subsequent exposure period. Further, the statistical variance of the detector signal increases monotonically with each successive exposure, which is illustrated using crosshatched regions between the dashed lines. Finally, the leak current exhibits a similar hysteresis effect as described in reference to FIGs. 8-9A, converging to leak current value that is significantly higher than the initial value at Tₒ. Together, these data reveal the importance of protecting detector surfaces from ion exposure, which has a progressive, persistent, and degradative effect on detector signal-to-noise properties. Advantageously, the filters of the present disclosure reduce or substantially eliminate the influence of ions on detector performance, permitting detectors to be placed in line-of-sight of a sample for processing by FIB instruments.

**FIGs. 10A-10B** are a block flow diagrams illustrating example processes 1000 and 1050 for active filtering of charged particle signals and acceleration of negatively charged particles, respectively, in accordance with some embodiments of the present disclosure. One or more operations of the example processes 1000 and 1050 can be executed by a computer system in communication with additional systems including, but not limited to, characterization systems, network infrastructure, databases, and user interface devices. In some embodiments, at least a subset of the operations described in reference to FIGs. 10A-10B are performed automatically (e.g., without human involvement) or pseudo-automatically (e.g., with human initiation or limited human intervention). In an illustrative example, operations for modifying a bias voltage on a conductive layer of a filter can be initiated by a human user and/or implemented automatically as part of a voltage sweep sub-process, and operations for generating detector data can be executed automatically, with the system 100 being configured to operate components of a charged particle beam system (e.g., example system 100 of FIG. 1). For example, while example process 1000 is described as a sequence of operations, it is understood that at least some of the operations can be omitted, repeated, and/or reordered. In some embodiments, additional operations precede and/or follow the operations of example process 1000 that are omitted for clarity of explanation, for example, operations for calibration of the electron source, alignment and aberration correction of the beam of electrons, initializing probe position or the like. Similarly, operations of processes 1000 and/or 1050 can be executed in series and/or in parallel, running concurrently and/or separately in time.

At operation 1005, example process 1000 includes applying a negative bias to the membrane of a filter placed between a sample position of a charged particle beam system and a detector oriented to collect particles emanating from the sample position. As described in more detail in reference to FIGs. 1-2, the detector can be a mirror detector, but can also be another detector, such that the detector is susceptible to degradation by exposure to particle flux, as described in more detail in reference to FIGs. 3A-3C and 8-9C. In this context, applying a negative bias to the membrane can include applying a voltage to an electrically conductive portion of a frame of the filter, as described in more detail in reference to FIG. 5. In this way, the negative bias corresponds to an energy cutoff of the particle filter, below which electrons having an energy below a corresponding threshold are repelled away from the second surface. Electrons having an average energy above the threshold can be absorbed and/or scattered by the filter membrane and/or can be transmitted through the filter membrane. To that end, operations of example process 1000 can be repeated for multiple values of the bias voltage, as an approach for selecting specific energies in a manner akin to a high-pass energy filter. Advantageously, this technique permits the filters of the present disclosure to add dynamic functionality to charged particle beam systems that is presently unavailable. Further, a high-pass filter operation permits selective removal of secondary electrons in favor of backscattered electrons, as an example.

At operation 1010, example process 1000 includes directing a beam of charged particles toward the sample position (e.g., sample 130 of FIG. 1). This operation can include multiple sub-operations for generating, modifying, steering, and controlling the beam, in accordance with a set of operating parameters that can be at least partially supplied by a user of the charged particle beam system. In some embodiments, operation 1010 includes directing a beam of electrons toward the sample, but can also include directing a focused ion beam toward the sample, for example, as part of an ion beam processing workflow. In this way, operation 1010 can include one or more operations that are not explicitly described as part of the present disclosure, but make up at least part of typical charged particle imaging, microanalysis, and/or sample preparation processes.

At operation 1015, example process 1000 includes generating detector data. As described in more detail in reference to the preceding figures, generating detector data can include generating a detector current signal that is proportional to a flux of incident particles onto a semiconducting acceptor layer of a solid state detector. The current signal can be modulated using a bias voltage applied across the acceptor layer, as described in more detail in reference to FIGs. 3A-3C (e.g., the current signal can be filtered using a negative bias potential). Further, operation 1015 can be executed concurrently with operation 1010, for example, as part of monitoring the progress of an ion-beam milling process or as part of electron beam modification of a sample.

In contrast to example process 1000, example process 1050 of FIG. 10B describes operations for increasing the detector signal for a given set of conditions by accelerating electrons toward the filter, thereby increasing the fraction of electrons that are transmitted through the filter. As described in more detail in reference to FIG. 6, transmissivity of the filter membrane to electrons can be energy-dependent for a given set of material properties and dimensions of the filter. To that end, augmenting the energy of the charged particles reaching the filter can increase the effective transmission fraction of the filter, thereby reducing the attenuation caused by charged particles being absorbed, reflected, and/or scattered by the filter.

At operation 1055, example process 1050 includes applying a positive bias to the membrane of a filter placed between a sample position of a charged particle beam system and a detector oriented to collect particles emanating from the sample position. Advantageously, the positive bias can serve two concurrent purposes, accelerating negatively charged particles (e.g., electrons) toward the detector, via the filter membrane, and decelerating positively charged particles (e.g., ions) prior to impacting the membrane that can reduce the extent of ion-induced damage to the material of the filter membrane. In this way, operation 1055 can improve the detector efficiency for a given electron flux by increasing the average energy of incident electrons, and can reduce the ion flux and average energy of ions hitting the filter.

Example process 1050 includes operations 1060 and 1065 that reproduce the operations 1010 and 1015 of example process 1000 of FIG. 10B. In some embodiments, operations of example process 1000 and 1050 can be combined in a single process, for example, when combining electron beam processing and ion beam processing, or when using the filter as a high-pass thresholding filter for electrons in a subset of processes making up a larger sample preparation workflow and for boosting the electron signal during another subset of processes of the sample preparation workflow.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on charged particle beam systems, and dual-beam systems in particular, these are meant as non-limiting, illustrative embodiments. Embodiments of the present disclosure are not limited to such embodiments, but rather are intended to address analytical instruments systems for which a wide array of material samples can be processed and/or analyzed to determine chemical, biological, physical, structural, or other properties, among other aspects, including instruments configured to prepare samples for further analysis (e.g., lamella preparation).

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to ±10%. For example, a dimension of "about 10 mm" can describe a dimension from 9 mm to 11 mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A filter, comprising:
a frame; and
a membrane of carbon material, coupled with the frame, the membrane defining a first surface, a second surface opposing the first surface, and an aperture extending through the membrane from the first surface to the second surface,
wherein:
the frame is configured to couple with a charged particle detector disposed in a charged particle beam column, the charged particle detector defining an absorption surface oriented toward the first surface; and
the filter being configured to shield the absorption surface from particles incident on the second surface, the particles comprising electrons, ions, or photons.

2. The filter of claim 1, wherein the carbon material comprises carbon nanotubes; and/or wherein the carbon material comprises a layer of nonwoven carbon nanotube felt.

3. The filter of any of claims 1-2, wherein the membrane comprises multiple substantially planar layers of carbon material.

4. The filter of any of claims 1-3, wherein the membrane is supported over at least a portion of the membrane by a support material.

5. The filter of any of claims 1-4, wherein the charged particle detector is disposed in a polepiece of the charged particle beam column.

6. The filter of any of claims 1-5, wherein the charged particle detector is a mirror detector including a mirror electrode, and wherein the frame is configured to couple with the mirror detector.

7. The filter of claim 6, wherein the mirror electrode defines a first end and a second end, the first end being proximal to the absorption surface, and wherein the frame is configured to be disposed proximal to the second end of the mirror electrode and external to the mirror detector.

8. The filter of claim 6, wherein the mirror electrode defines a first end and a second end, the first end being proximal to the absorption surface, and wherein the frame is configured to be disposed in the polepiece, proximal to the first end of the mirror electrode and internal to the mirror detector.

9. The filter of any of claims 6-8, wherein the charged particle detector and the mirror electrode are disposed along a beam axis, and wherein the frame is disposed on the beam axis between the charged particle detector and the mirror electrode.

10. The filter of any of claims 1-9, wherein the frame is offset from the absorption surface.

11. The filter of any of claims 1-10, wherein the frame comprises an electrically conductive portion, electrically coupled with the membrane and with a voltage source via a bias circuit.

12. A charged particle beam system, comprising:
a chamber, configured to receive a sample and to maintain a controlled environment in a vicinity of the sample;
a charged particle beam column, coupled with the chamber and oriented toward the vicinity of the sample;
a charged particle detector, disposed in the charged particle beam column, the charged particle detector defining an absorption surface; and
a particle filter according to any of claims 1-12.

13. The charged particle beam system of claim 12, further comprising:
control circuitry, operably coupled with the bias circuit; and
one or more computer-readable media comprising instructions that, when executed by a computer, cause the control circuitry to perform operations including applying a negative bias to the membrane via the electrically conductive portion, wherein the negative bias corresponds to a lower energy cutoff of the particle filter, below which electrons directed toward the second surface are repelled.

14. The charged particle beam system of claim 13, further comprising:
control circuitry, operably coupled with the bias circuit; and
one or more computer-readable media comprising instructions that, when executed by a computer, cause the control circuitry to perform operations including applying a positive bias to the membrane via the electrically conductive portion; and
optionally wherein the positive bias has a magnitude such that electrons incident on the second surface are **characterized by** an average energy above a threshold of transmissivity of the membrane for electrons.

15. The charged particle beam system of any of claims 12-14, wherein the charged particle detector comprises a conductive material disposed over at least a portion of the absorption surface, wherein the charged particle detector is electrically coupled to a voltage source via a bias circuit, and wherein the charged particle beam system is configured to apply a bias voltage to the conductive material via the bias circuit.
